## Europäisches Patentamt

## European Patent Office

## Office européen des brevets

(11) Veröffentlichungsnummer: **0 092 710**
**B1**

(12) # EUROPÄISCHE PATENTSCHRIFT

(45) Veröffentlichungstag der Patentschrift:
23.07.86

(51) Int. Cl.⁴: **H 03 K 17/945**

(21) Anmeldenummer: **83103393.1**

(22) Anmeldetag: **07.04.83**

(54) Elektronisches, vorzugsweise berührungslos arbeitendes Schaltgerät.

(30) Priorität: **21.04.82 DE 3214835**
**16.10.82 DE 3238396**

(43) Veröffentlichungstag der Anmeldung:
**02.11.83 Patentblatt 83/44**

(45) Bekanntmachung des Hinweises auf die Patenterteilung:
**23.07.86 Patentblatt 86/30**

(84) Benannte Vertragsstaaten:
**AT BE CH DE FR GB IT LI LU NL SE**

(56) Entgegenhaltungen:
**DE-A-2 753 869**
**DE-A-2 808 156**
**DE-B-2 330 233**
**DE-B-2 446 454**
**JP-A-56 131 229**
**US-A-3 581 105**

**RADIO FERNSEHEN ELEKTRONIK, Band 26, Nr. 12,
Juni 1977 D. BUTTGEREIT "Die integrierte
Initiatorschaltung A 301 D" Seiten 403-406**
**Patent Abstracts of Japan Band 3, Nr. 90, 31. Juli
1979 Seite 107E127**

(73) Patentinhaber: **i f m electronic gmbh, Teichstrasse
4, D-4300 Essen 1 (DE)**

(72) Erfinder: **Buck, Robert, Ing. (grad.), Am Kirchbühl
28, D-7995 Neukirch (DE)**
Erfinder: **Lamarche, Jean Luc, Dipl.- Ing.,
Zeppelinstrasse 1, D-7994 Langenargen (DE)**
Erfinder: **Spaehn, Peter, Ing. (grad.), Birkensteige
24, D-7992 Tettnang (DE)**

(74) Vertreter: **Gesthuysen, Hans Dieter, Dipl.- Ing.,
Patentanwälte Gesthuysen + von Rohr
Huyssenallee 15 Postfach 10 13 33, D-4300 Essen
1 (DE)**

## Beschreibung

Die Erfindung betrifft ein elektronisches, vorzugsweise berührungslos arbeitendes Schaltgerät, das über einen Außenleiter mit einem Pol einer Gleichspannungsquelle und nur über einen weiteren Aunenleiter mit einem Anschluß eines Verbrauchers verbindbar ist, wobei der andere Anschluß des Verbrauchers an den anderen Pol der Gleichspannungsquelle anschließbar ist, mit einem von außen beeinflußbaren Anwesenheitsindikator, z. B. einem Oszillator, mit einem von dem Anwesenheitsindikator, ggf. über einen Schaltverstärker steuerbaren elektronischen Schalter, z. B. einem Transistor oder einem Thyristor, und mit einer Hilfsschaltung zur Erzeugung einer Hilfsspannung für den Anwesenheitsindikator und ggf. den Schaltverstärker, wobei die Hilfsschaltung zur Erzeugung einer Hilfsspannung für den Anwesenheitsindikator und ggf. den Schaltverstärker einen Konstantstromgenerator und ein Spannungsbegrenzungselement aufweist.

Elektronische Schaltgeräte der zuvor beschriebenen Art sind kontaktlos ausgeführt und werden in zunehmendem Maße anstelle von elektrischen, mechanisch betätigten Schaltgeräten, die kontaktbehaftet ausgeführt sind, in elektrischen Meß-, Steuer- und Regelkreisen verwendet. Das gilt insbesondere für sogenannte Annäherungsschalter, d. h. für elektronische Schaltgeräte, die berührungslos arbeiten. Mit solchen Annäherungsschaltern wird indiziert, ob sich ein Beeinflussungselement, für das der entsprechende Annäherungsschalter sensitiv ist, dem Annäherungsschalter hinreichend weit genähert hat. Hat sich nämlich ein Beeinflussungselement, für das der entsprechende Annäherungsschalter sensitiv ist, dem Anwesenheitsindikator hinreichend weit genähert, so steuert der Anwesenheitsindikator den elektronischen Schalter um, d. h. bei einem als Schliener ausgeführten Schaltgerät wird der nichtleitende elektronische Schalter nunmehr leitend, während bei einem als öffner ausgeführten Schaltgerät der leitende elektronische Schalter nunmehr sperrt. (Mit Schaltgeräten der in Rede stehenden Art kann auch indiziert werden, ob eine physikalische Größe eines Beeinflussungsmediums, für die das Schaltgerät sensitiv ist, einen entsprechenden Wert erreicht hat.)

Wesentlicher Bestandteil von elektronischen Schaltgeräten der zuvor beschriebenen Art ist also u. a. der von aunen beeinflußbare Anwesenheitsindikator. Als Anwesenheitsindikator kann z. B. ein induktiv oder kapazitiv beeinflußbarer Oszillator vorgesehen sein; es handelt sich dann um induktive oder kapazitive Annäherungsschalter (vgl. z. B. die deutschen Offenlegungsschriften bzw. Auslegeschriften bzw. Patentschriften 19 5l 137, l9 66 178, 19 66 213, 20 36 840, 21 27 956, 22 03 038, 22 03 039, 22 03 040, 22 03 906, 23 30 233, 23 31 732. 23 56 490, 26 13 423, 26 16 265, 28 16 773, 26 28 427, 27 11 877 und 27 44 785). Als Anwesenheitsindikator kann z. B. auch ein Fotowiderstand, eine Fotodiode oder ein Fototransistor vorgesehen sein; es handelt sich dann um optoelektronische Annäherungsschalter (vgl. z. B. die deutsche Offenlegungsschrift 28 24 582).

Bei induktiven Annäherungsschaltern gilt für den Oszillator, solange ein Metallteil einen vorgegebenen Abstand noch nicht erreicht hat, K. V = 1 mit K = Rückkopplungsfaktor und V = Verstärkungsfaktor des Oszillators, d. h. der Oszillator schwingt. Erreicht das entsprechende Metallteil den vorgeschriebenen Abstand, so führt die zunehmende Bedämpfung des Oszillators zu einer Verringerung des Verstärkungsfaktors V, so daß K. V < 1 wird, d. h. der Oszillator hört auf zu schwingen. Bei kapazitiven Annäherungsschaltern gilt für den Oszillator, solange ein Ansprechkörper die Kapazität zwischen einer Ansprechelektrode und einer Gegenelektrode noch nicht hinreichend vergrößert hat, also einen vorgegebenen Abstand noch nicht erreicht hat, K - V = 1, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors K, so daß K. V = 1 wird, d. h. der Oszillator beginnt zu schwingen. Bei beiden Ausführungsformen wird abhängig von den unterschiedlichen Zuständen des Oszillators der elektronische Schalter, z. B. ein Transistor, ein Thyristor oder ein Triac, gesteuert.

Optoelektronische Annäherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer überwachungsstrecke angeordnet sind, und einem Lichtschrankentyp, bei dem der Lichtsender und der Lichtempfänger am gleichen Ende einer überwachungsstrecke angeordnet sind, während ein am anderen Ende der überwachungsstrecke angeordneter Reflektor den vom Lichtsender ausgehenden Lichtstrahl zum Lichtempfänger zurückreflektiert. In beiden Fällen spricht der Anwesenheitsindikator an, wenn der normalerweise vom Lichtsender zum Lichtempfänger gelangende Lichtstrahl durch ein in die überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurückreflektiert wird.

Elektronische, berührungslos arbeitende Schaltgeräte sind anfangs mit einer Reihe von Problemen behaftet gewesen, - gemessen an elektrischen, mechanisch betätigten Schaltgeräten -, nämlich u.a. mit den Problemen "Erzeugung einer Speisespannung für den Oszillator", "Ausbildung des Oszillators" "Einschaltimpulsverhinderung"
"Kurzschlunfestigkeit". Mit diesen Problemen und deren Lösungen (und mit anderen bei elektronischen, berührungslos arbeitenden Schaltgeräten relevanten Problemen und deren Lösungen) befassen sich z. B. die deutschen Offenlegungsschriften bzw. Auslegeschriften bzw. Patentschriften 19 51 137, 19 66 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 773, 26 28 427, 27 11 877, 27 44 785, 29 43 911, 30 04 829, 30 38 102, 30 38 141 und 30 38 692 sowie die USA-Patentschrift 35 81 105.

Bei elektronischen Schaltgeräten, die über einen Außenleiter mit einem Pol einer Spannungsquelle und nur über einen weiteren Außenleiter mit einem Anschluß eines Verbrauchers verbindbar sind, ist die Erzeugung einer Hilfsspannung für den Anwesenheitsindikator und ggf. den Schaltverstärker nicht problemlos, weil ja sowohl im leitenden Zustand als auch im gesperrten Zustand des Schaltgerätes die Hilfsspannung erzeugt werden muß, - die einen Hilfsstrom zur Folge hat, so daß letzten Endes einem solchen Schaltgerät im leitenden Zustand und im gesperrten Zustand eine elektrische Hilfsleistung zugeführt werden mun (Hilfsleistung als Produkt aus Hilfsspannung und Hilfsstrom). Von ihrer Funktion als Schaltgeräte her soll aber bei den in Rede stehenden elektronischen Schaltgeräten im leitenden Zustand praktisch kein Spannungsabfall auftreten und im gesperrten Zustand praktisch kein Reststrom flienen. Da dann wenn bei Schaltgeräten der in Rede stehenden Art im leitenden Zustand kein Spannungsabfall auftritt, auch keine Hilfsspannung gewonnen werden kann und dann, wenn im gesperrten Zustand kein Reststrom fließt, auch kein Hilfsstrom gewonnen werden kann, gilt für alle elektronischen Schaltgeräte mit nur zwei Außenleitern, dan im leitenden Zustand ein Spannungsabfall auftritt und im gesperrten Zustand ein Reststrom flient.

Wie eingangs ausgeführt, weist bei den Schaltgeräten, von denen die Erfindung ausgeht (vgl. die JP-AS 56-131.229), die Hilfsschaltung zur Erzeugung einer Hilfsspannung für den Anwesenheitsindikator und ggf. den Schaltverstärker einen Konstantstromgenerator und ein Spannungsbegrenzungselement auf. Dabei wird über den Konstantstromgenerator dem Anwesenheitsindikator und ggf. dem Schaltverstärker der benötigte Hilfsstrom zugeführt und sorgt das Spannungsbegrenzungselement, z. B. eine Zenerdiode, dafür, daß am Anwesenheitsindikator und ggf. am Schaltverstärker die erforderliche Hilfsspannung ansteht.

Im übrigen gilt für das bekannte Schaltgerät, von dem die Erfindung ausgeht, dan der Konstantstromgenerator einerseits und die Parallelschaltung des Anwesenheitsindikators und des Spannungsbegrenzungselements andererseits eine Reihenschaltung bilden und dan dieser Reihenschaltung eine Schaltungsanordnung parallelgeschaltet ist, die aus vier Transistoren, fünf Widerständen und einer Diode bzw. aus fünf Transistoren, sechs Widerständen und einer Diode besteht und die - im leitenden Zustand - wie eine Zenerdiode mit einer wenig ausgeprägten Zenerspannung wirkt. Entscheidend ist dabei, daß bei diesem bekannten Schaltgerät im leitenden Zustand der Spannungsabfall resultiert aus dem Spannungsabfall an der Parallelschaltung aus dem Anwesenheitsindikator und dem Spannungsbegrenzungselement, also der Hilfsspannung, und dem Spannungsabfall am Konstantstromgenerator.

Der Erfindung liegt nun die Aufgabe zugrunde, das bekannte elektronische Schaltgerät, von dem die Erfindung ausgeht, so auszugestalten und weiterzubilden, daß im leitenden Zustand ein geringerer Spannungsabfall auftritt.

Das erfindungsgemäße Schaltgerät, bei dem die zuvor aufgezeigte Aufgabe gelöst ist, ist nun dadurch gekennzeichnet, daß dem Konstantstromgenerator ein Transistor oder ein Thyristor als Hilfsschalter parallelgeschaltet ist, daß der Hilfsschalter von dem Anwesenheitsindikator - ggf. über den Schaltverstärker - steuerbar ist und daß im leitenden Zustand der Hauptteil des Laststroms über die Emitter-Basis-Strecke des als Hilfsschalter vorgesehenen Transistors oder über die Anoden-Kathoden-Strecke des als Hilfsschalter vorgesehenen Thyristors fließt und aus einem Hilfsteil des Laststroms die Hilfsspannung für den Anwesenheitsindikator und ggf. den Schaltverstärker gewonnen wird.

Dadurch, daß erfindungsgemäß dem Konstantstromgenerator ein Transistor oder ein Thyristor als Hilfsschalter - in der beschriebenen Weise - parallelgeschaltet ist, wird dann, wenn das erfindungsgemäße elektronische Schaltgerät in den leitenden Zustand gesteuert wird, auch der Hilfsschalter leitend gesteuert, so daß dann der Hilfsschalter "wirksam" dem Konstantstromgenerator parallelgeschaltet ist, also statt des vorher am Konstantstromgenerator aufgetretenen Spannungsabfalls nunmehr nur noch der Spannungsabfall am Hilfsschalter auftritt, der zusammen mit der benötigten Hilfsspannung für den Anwesenheitsindikator und ggf. den Schaltverstärker als Spannungsabfall des elektronischen Schaltgerätes im leitenden Zustand auftritt. Im einzelnen gibt es verschiedene Möglichkeiten, das erfindungsgemäße elektronische Schaltgerät auszugestalten und weiterzubilden, was im folgenden nur beispielhaft erläutert werden soll.

Zunächst kann bei dem erfindungsgemäßen elektronischen Schaltgerät der Konstantstromgenerator in unterschiedlicher Weise ausgeführt sein. Eine relativ einfache Ausführungsform ist insoweit dadurch gekennzeichnet, daß der Konstantstromgenerator aus einem in Emitterschaltung betriebenen Generatortransistor, einem an die Basis und an den Kollektor des Generatortransistors angeschlossenen Strombegrenzungswiderstand,

dem an die Basis des Generatortransistors angeschlossenen Spannungsbegrenzungselement, z. B. einer Zenerdiode, und einer an den Emitter des Generatortransistors angeschlossenen Emitterlast besteht. Dabei führt der über das Spannungsbegrenzungselement fließende Strom zu einer konstanten Spannung an der Basis des Generatortransistors und damit auch zu einer konstanten Spannung am Emitter des Generatortransistors, - weil nämlich die Spannung am Emitter des Generatortransistors um den weitgehend konstanten Spannungsabfall an der Basis-Emitter-Strecke des Generatortransistors unter der Spannung an der Basis des Generatortransistors liegt. Die am Emitter des Generatortransistors entstehende konstante Spannung führt zu einem konstanten Strom in die Emitterlast, wenn, wovon ausgegangen werden kann, die Emitterlast weitgehend konstant ist.

Zu der Lehre der Erfindung gehört, daß dem Konstantstromgenerator ein elektronischer Hilfsschalter parallelgeschaltet ist. Das ist im Sinne der insoweit bereits gegebenen Erläuterung natürlich nur funktional zu verstehen. So kann der Hilfsschalter der Kollektor-Emitter-Strecke des Generatortransistors des als Konstantstromgenerator ausgeführten Stromzuführungselements parallelgeschaltet sein.

Besondere Bedeutung hat die Lehre der Erfindung dann, wenn die Emitterlast teilweise als monolitisch integrierter Schaltkreis ausgeführt ist und in dem integrierten Schaltkreis teilweise die Bauelemente des Anwesenheitsindikators und ggf. des Schaltverstärkers verwirklicht sind. Hier empfiehlt es sich dann, den Hilfsschalter an den integrierten Schaltkreis anzuschließen und über den integrierten Schaltkreis zu steuern.

Selbstverständlich kann der bei dem erfindungsgemäßen elektronischen Schaltgerät dem Konstantstromgenerator parallelgeschaltete Hilfsschalter unterschiedlich ausgeführt sein, wobei es sich empfehlen kann, den Hilfsschalter über einen Ansteuertransistor anzusteuern.

In bezug auf die Ausführung des dem Konstantstromgenerator parallelgeschalteten Hilfsschalters ist eine erste Ausführungsform des erfindungsgemäßenelektronischen Schaltgerätes dadurch gekennzeichnet, daß als Hilfsschalter ein Transistor vorgesehen ist. Im einzelnen ist eine konkrete Ausgestaltung dieser Ausführungsform des erfindungsgemäßen Schaltgerätes dadurch gekennzeichnet, daß zu der Emitter-Kollektor-Strecke des als Hilfsschalter vorgesehenen Transistors die Emitter-Kollektor-Strecke als Ansteuertransistors in Reihe geschaltet ist, ein Ergänzungstransistor vorgesehen ist sowie die Basis des als Hilfsschalter vorgesehenen Transistors an den Kollektor des Ergänzungstransistors und der Kollektor des Ansteuertransistors an die Basis des Ergänzungstransistors angeschlossen sind, - während der Emitter des als Hilfsschalter vorgesehenen Transistors an den Pluspol der Gleichspannungsquelle und der Emitter des Ergänzungstransistors an den Minuspol der Gleichspannungsquelle angeschlossen sind und der Hilfsschalter, der Ansteuertransistor und der Ergänzungstransistor zusammen den elektronischen Schalter darstellen.

Eine zweite Ausführungsform des erfindungsgemäßen elektronischen Schaltgerätes ist in bezug auf die Ausführung des dem Stromzuführungselement parallelgeschalteten Hilfsschalter dadurch gekennzeichnet, daß als Hilfsschalter ein Thyristor vorgesehen ist. Im übrigen kann diese Ausführungsform entsprechend der zuvor beschriebenen Ausführungsform realisiert sein. Nach der Lehre der Erfindung fließt bei dem erfindungsgemäßen elektronischen Schaltgerät im leitenden Zustand der Hauptteil des Laststroms über die Emitter-Basis-Strecke des als Hilfsschalter vorgesehenen Transistors bzw. über die Anoden-Kathoden-Strecke des als Hilfsschalter vorgesehenen Thyristors und wird aus einem Hilfsteil des Laststroms die Hilfsspannung für den Anwesenheitsindikator und ggf. den Schaltverstärker gewonnen. Dabei kann zur Gewinnung der Hilfsspannung für aus den Anwesenheitsindikator und ggf. den Schaltverstärker aus einem Hilfsteil des Laststroms eine Zenerdiode vorgesehen sein.

Vorteilhafter als die zuletzt beschriebene Ausführungsform des erfindungsgemäßen elektronischen Schaltgerätes, bei der zur Gewinnung der Hilfsspannung für den Anwesenheitsindikator und ggf. den Schaltverstärker aus einem Hilfsteil des Laststroms eine Zenerdiode vorgesehen ist, ist eine andere besonders bevorzugte Ausführungsform des erfindungsgemäßen elektronischen Schaltgerätes, bei der die Hilfsschaltung zur Erzeugung einer Hilfsspannung für den Anwesenheitsindikator und ggf. den Schaltverstärker einen Spannungsregler zur Erzeugung einer konstanten Referenzspannung aufweist, - so daß ein Referenzpotential zur Verfügung steht. Diese Ausführungsform kann konkret unterschiedlich realisiert werden. Eine erste Realisierungsmöglichkeit ist dadurch gekennzeichnet, daß ein Vergleichstransistor (oder ein anderer Komparator) vorgesehen ist und die Basis des Vergleichstransistors an das Referenzpotential, der Emitter des Vergleichstransistors über einen von dem Anwesenheitsindikator oder dem Schaltverstärker angesteuerten Steuerschalter an die Verbindung von Konstantstromgenerator und Hilfsschalter und der Kollektor des Vergleichstransistors an den elektronischen Schalter angeschlossen sind, - wenn die Hilfsspannung für den Anwesenheitsindikator und ggf. den Schaltverstärker bzw. die Referenzspannung die Potentialdifferenz zwischen dem Hilfspotential bzw. dem Referenzpotential und dem Minuspotential sind, bzw. entsprechend invers, wenn die Hilfsspannung für den Anwesenheitsindikator und ggf. den Schaltverstärker bzw. die Referenzspannung die

,tentialdifferenz zwischen dem Hilfspotential bzw. dem Referenzpotential und dem Pluspotential sind. Eine zweite Realisierungsmöglichkeit der Ausführungsform mit einem Spannungsregler zur Erzeugung einer konstanten Referenzspannung ist dadurch gekennzeichnet, daß ein Vergleichstransistor (oder ein anderer Komparator) vorgesehen ist und die Basis des Vergleichstransistors an das Referenzpotential, der Emitter des Vergleichstransistors an das Pluspotential und der Kollektor des Vergleichstransistors entweder über einen Öffner eines von dem Anwesenheitsindikator oder von dem Schaltverstärker angesteuerten Steuerschalters an das Minuspotential oder über einen Schließer des Steuerschalters an die Basis eines den elektronischen Schalter ansteuernden Hilfstransistors angeschlossen sind, - wenn die Hilfsspannung für den Anwesenheitsindikator und ggf. den Schaltverstärker bzw. die Referenzspannung die Potentialdifferenz zwischen dem Hilfspotential bzw. dem Referenzpotential und dem Pluspotential sind, bzw. entsprechend invers, wenn die Hilfsspannung für den Anwesenheitsindikator und ggf. den Schaltverstärker bzw. die Referenzspannung die Potentialdifferenz zwischen dem Hilfspotential bzw. dem Referenzpotential und dem Minuspotential sind. Schließlich ist eine dritte Realisierungsmöglichkeit der Ausführungsform mit einem Spannungsregler zur Erzeugung einer konstanten Referenzspannung dadurch gekennzeichnet, daß ein Vergleichstransistor (oder ein anderer Komparator) vorgesehen ist und die Basis des Vergleichstransistors an das Referenzpotential, der Emitter des Vergleichstransistors an das Pluspotential und der Kollektor des Vergleichstransistors an den Emitter des als Transistor ausgeführten elektronischen Schalters und an den Emitter eines Hilfstransistors angeschlossen sind, der Kollektor des als Transistor ausgeführten elektronischen Schalters an die Basis des als Transistor ausgeführten Hilfsschalters und der Kollektor des Hilfstransistors an das Hilfspotential angeschlossen sind sowie entweder die Basis des als Transistor ausgeführten elektronischen Schalters über einen Schließer eines von dem Anwesenheitsindikator oder von dem Schaltverstärker angesteuerten Steuerschalters oder die Basis des Hilfstransistors über einen Öffner des Steuerschalters angesteuert sind, - wenn die Hilfsspannung für den Anwesenheitsindikator und ggf. den Schaltverstärker bzw. die Referenzspannung die Potentialdifferenz zwischen dem Hilfspotential bzw. dem Referenzpotential und dem Pluspotential sind, bzw. entsprechend invers, wenn die Hilfsspannung für den Anwesenheitsindikator und ggf. den Schaltverstärker bzw. die Referenzspannung die Potentialdifferenz zwischen dem Hilfspotential bzw. dem Referenzpotential und dem Minuspotential sind.

Im folgenden wird die Erfindung anhand einer lediglich Ausführungsbeispieldarstellenden Zeichnung nochmals erläutert; es zeigt

Fig. 1 stark schematisiert das Schaltbild einer ersten Ausführungsform eines erfindungsgemäßen Schaltgerätes,

Fig. 2 detaillierter als in Fig. 1, das Schaltbild einer zweiten Ausführungsform eines erfindungsgemäßen Schaltgerätes,

Fig. 3 weniger detailliert als in Fig. 2, das Schaltbild einer dritten Ausführungsform eines erfindungsgemäßen Schaltgerätes,

Fig. 4 einen Ausschnitt aus dem Schaltbild einer dritten Ausführungsform eines erfindungsgemäßen Schaltgerätes,

Fig. 5 einen Ausschnitt aus dem Schaltbild einer vierten Ausführungsform eines erfindungsgemäßen Schaltgerätes,

Fig. 6 einen Ausschnitt aus dem Schaltbild einer fünften Ausführungsform eines erfindungsgemäßen Schaltgerätes,

Fig. 7 einen Ausschnitt aus dem Schaltbild einer sechsten Ausführungsform eines erfindungsgemäßen Schaltgerätes und

Fig. 8 einen Ausschnitt aus dem Schaltbild einer siebten Ausfürungsform eines erfindungsgemäßen Schaltgerätes.

Die in den Figuren dargestellten elektronischen Schaltgeräte 1 arbeiten berührungslos und sind jeweils, was in den Figuren nicht dargestellt ist, über einen Außenleiter mit einem Pol einer Gleichspannungsquelle und nur über einen weiteren Außenleiter mit einem Anschluß eines Verbrauchers verbindbar, wobei der andere Anschluß des Verbrauchers an den anderen Pol der Gleichspannungsquelle anschließbar ist; es handelt sich also um Gleichspannungsgeräte mit nur zwei Außenleitern.

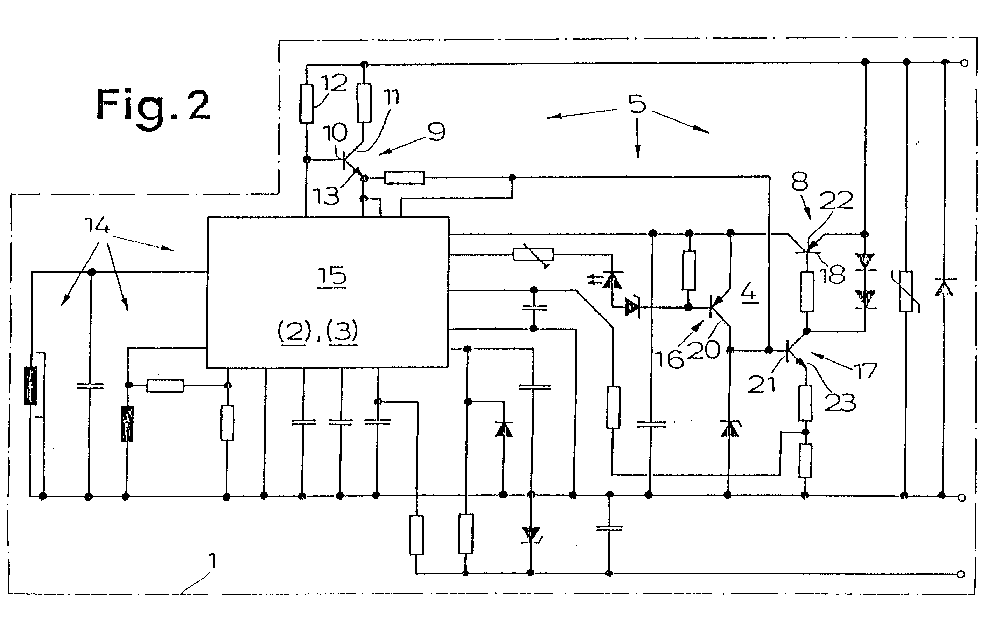

In ihrem wesentlichen Aufbau bestehen die in den Figuren dargestellten Schaltgeräte 1 aus einem von außen beeinflußbaren Anwesenheitsindikator 2, z. B., wie in Fig. 2 angedeutet, einem Oszillator, aus einem von dem Anwesenheitsindikator 2 über einen Schaltverstärker 3 steuerbaren elektronischen Schalter 4 und aus einer Hilfsschaltung 5 zur Erzeugung einer Hilfsspannung für den Anwesenheitsindikator 2 und den Schaltverstärker 3. Die Hilfsschaltung 5 zur Erzeugung einer Hilfsspannung für den Anwesenheitsindikator 2 und den Schaltverstärker 3 weist einen Konstantstromgenerator 6 und ein Spannungsbegrenzungselement 7 auf.

Erfindungsgemäß ist dem Konstantstromgenerator 8 ein Transistor oder ein Thyristor als Hilfsschalter 8 parallelgeschaltet, ist der Hilfsschalter 8 von dem Anwesenheitsindikator 2 - über den Schaltverstärker 3 - steuerbar, fließt im leitenden Zustand der Hauptteil des Laststroms über die Emitter-Basis-Strecke des als Hilfsschalter 8 vorgesehenen Transistors oder über die Anoden-Kathoden-Strecke des als Hilfsschalter 8 vorgesehenen Thyristors und wird aus einem Hilfsteil des Laststroms die Hilfsspannung für den Anwesenheitsindikator 2 und den Schaltverstärker 3 gewonnen.

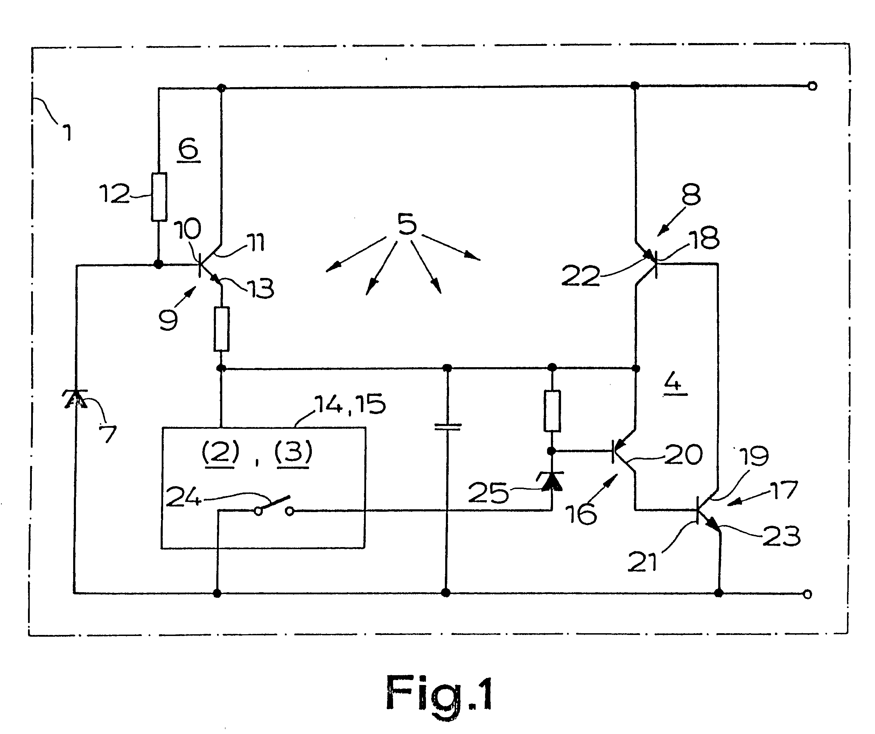

In allen dargestellten Ausführungsbeispielen besteht der Konstantstromgenerator 6 aus einem in Emitterschaltung betriebenen Generatortransistor 9, einem an die Basis 10 und an den Kollektor 11 angeschlossenen Strombegrenzungswiderstand 12, dem an die Basis 10 des Generatortransistors 9 angeschlossenen Spannungsbegrenzungselement 7, in dem in Fig. 1 dargestellten Ausführungsbeispiel einer Zenerdiode, und eine an den Emitter 13 des Generatortransistors 9 angeschlossenen Emitterlast 14.

Nur angedeutet ist, daß in allen Ausführungsbeispielen des erfindungsgemäßen Schaltgerätes 1 die Emitterlast 14 teilweise als monolitisch integrierter Schaltkreis 15 ausgeführt ist, in dem teilweise die Bauelemente des Anwesenheitsindikators 2 und des Schaltverstärkers 3 verwirklicht sind.

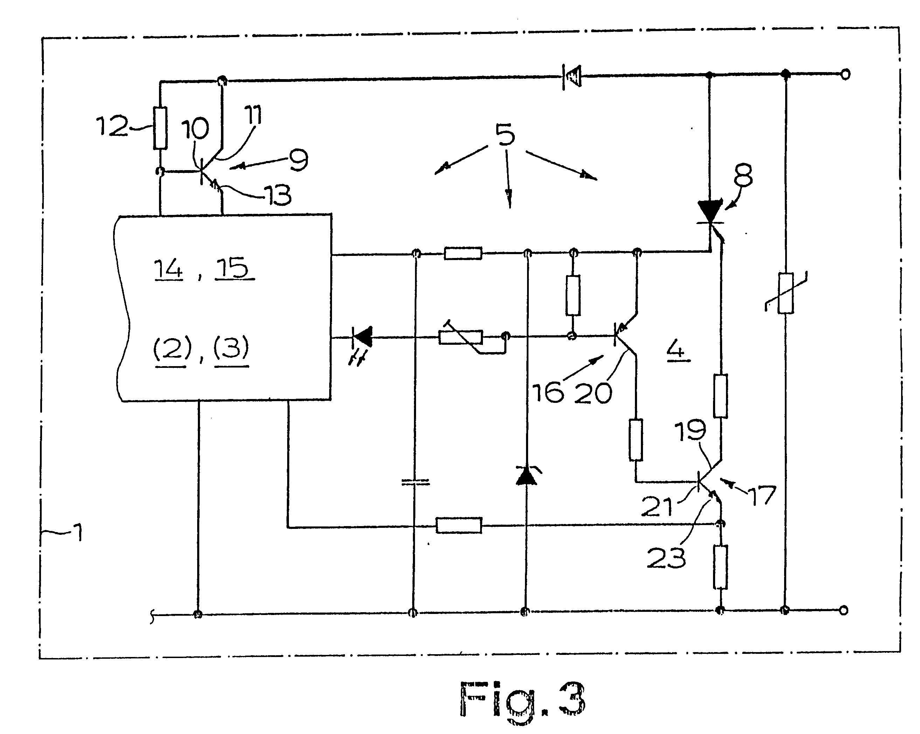

Während in den Ausführungsbeispielen nach den Fig. 1 und 4 bis 8 der Hilfsschalter 8 erkennbar dem Konstantstromgenerator 6 parallelgeschaltet ist, ist in den Ausführungsbeispielen nach den Fig. 2 und 3 der Hilfsschalter 8 an den integrierten Schaltkreis 15 angeschlossen und über den integrierten Schaltkreis 15 steuerbar.

Den in den Fig. 1 bis 3 dargestellten Ausführungsbeispielen des erfindungsgemäßen elektronischen Schaltgerätes 1 ist gemeinsam, daß der Hilfsschalter 8 über einen Ansteuertransistor 16 steuerbar ist.

In den in den Fig. 1 und 2 dargestellten Ausführungsbeispielen ist als Hilfsschalter 8 ein Transistor vorgesehen. Dabei ist die Ausführungsform konkret so realisiert, daß zu der Emitter-Kollektor-Strecke des als Hilfsschalter 8 vorgesehenen Transistors die Emitter-Kollektor-Strecke des Ansteuertransistors 16 in Reihe geschaltet ist, ein Ergänzungstransistor 17 vorgesehen ist sowie die Basis 18 des als Hilfsschalter 8 vorgesehenen Transistors an den Kollektor 19 des Ergänzungstransistors 17 und der Kollektor 20 des Ansteuertransistors 16 an die Basis 21 des Ergänzungstransistors 17 angeschlossen sind, - während der Emitter 22 des als Hilfsschalter 8 vorgesehenen Transistors an den Pluspol der Gleichspannungsquelle und der Emitter 23 des Ergänzungstransistors 17 an den Minuspol der Gleichspannungsquelle angeschlossen sind und der Hilfsschalter 8, der Ansteuertransistor 16 und der Ergänzungstransistor 17 zusammen den elektronischen Schalter 4 darstellen.

Im Ausführungsbeispiel nach Fig. 3 ist als Hilfsschalter 8 ein Thyristor vorgesehen. Das hat den Vorteil, daß das so ausgeführte erfindungsgemäße elektronische Schaltgerät 1 "verpolt" werden kann, ohne daß es eines besonderen Verpolungsschutzes bedarf. Im übrigen entspricht das in Fig. 3 dargestellte Ausführungsbeispiel eines erfindungsgemäßen Schaltgerätes 1 weitgehend dem in Fig. 2 dargestellten Ausführungsbeispiel.

Im übrigen zeigt insbesondere die Fig. 2 Schaltungsdetails des Aufbaus eines elektronischen Schaltgerätes 1, die hier der weitergehenden Erläuterung nicht bedürfen, insbesondere auch deshalb, weil die detailliert dargestellte Schaltung mit den einzelnen Bauelementen ohne weiteres nachvollziehbar ist.

Zur Funktionsweise der in den Figuren dargestellten erfindungsgemäßen elektronischen Schaltgeräte 1 ist mit Bezug auf die Fig. 1 noch zu sagen, daß hier durch einen innerhalb des integrierten Schaltkreises 15 angedeuteten Schalter 24 das Steuern des Hilfsschalters 8 durch den Anwesenheitsindikator 2 - über den Schaltverstärker 3 - angesprochen ist. Ist der Schalter 24 geöffnet, so sind der Hilfsschalter 8, der Ansteuertransistor 16 und der Ergänzungstransistor 17 sperrend. Ist dagegen der Schalter 24 geschlossen, so sind der Hilfsschalter 8, der Ansteuertransistor 16 und der Ergänzungstransistor 17 leitend.

Allen dargestellten Ausführungsbeispielen ist gemeinsam, daß im leitenden Zustand der Hauptteil des Laststroms über die Emitter-Basis-Strecke des als Hilfsschalter 8 vorgesehenen Transistors (Fig. 1, 2 und 4 bis 8) bzw. über die Anoden-Kathoden-Strecke des als Hilfsschalter 8 vorgesehenen Thyristors (Fig. 3) fließt und aus einem Hilfsteil des Laststroms die Hilfsspannung für den Anwesenheitsindikator 2 und den Schaltverstärker 3 gewonnen wird.

In den Ausführungsbeispielen, die in den Fig. 1 bis 3 dargestellt sind, ist zur Gewinnung der Hilfsspannung für den Anwesenheitsindikator 2 und den Schaltverstärker 3 aus einem Hilfsteil des Laststroms eine Zenerdiode 25 vorgesehen.

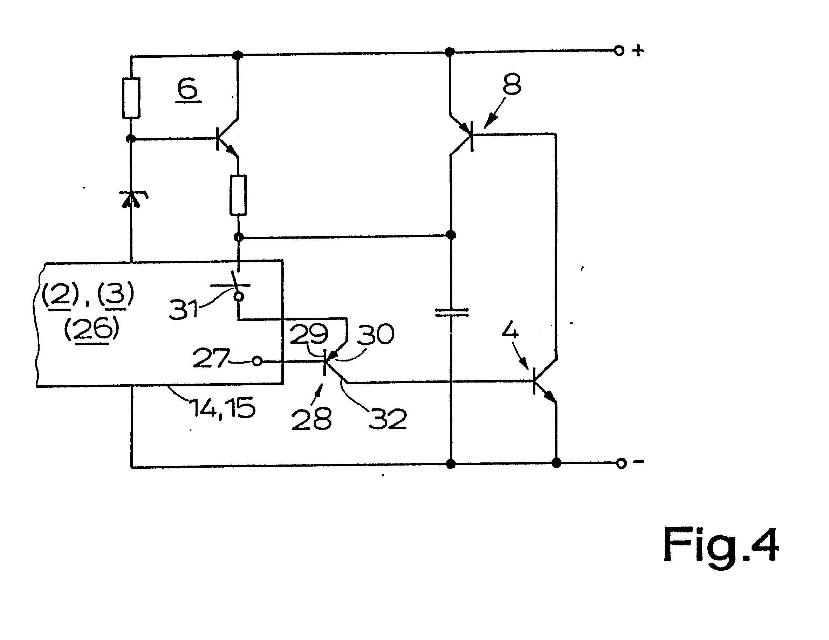

Bei den Ausführungsbeispielen von erfindungsgemäßen elektronischen Schaltgeräten, deren Schaltbilder in den Fig. 4 bis 8 nur ausschnittsweise wiedergegeben sind, weist die Hilfsschaltung zur Erzeugung einer Hilfsspannung für den Anwesenheitsindikator 2 und den Schaltverstärker 3 einen Spannungsregler 26 zur Erzeugung einer konstanten Referenzspannung auf, - so daß ein Referenzpotential 27 zur Verfügung steht. Weiter ist ein Vergleichstransistor 28 vorgesehen, dessen Basis 29 an das Referenzpotential 28 angeschlossen ist.

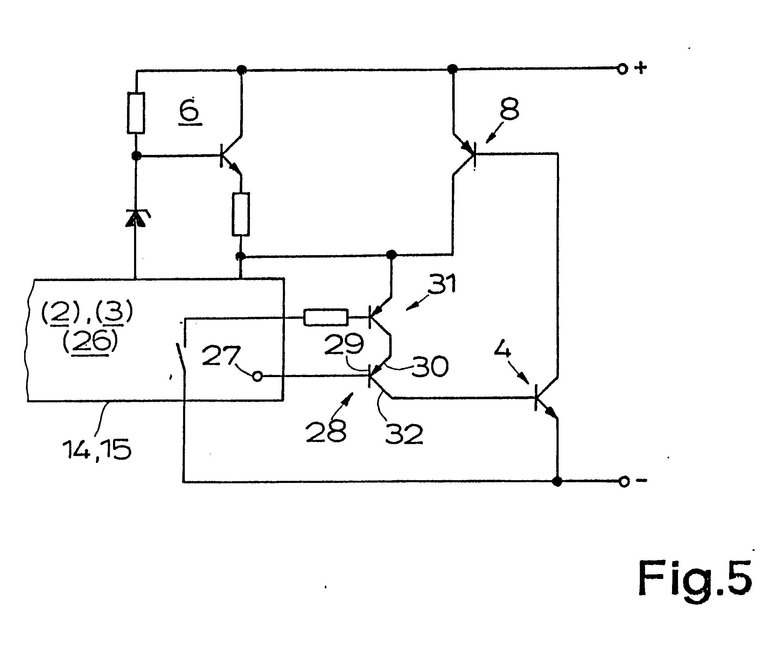

In den Ausführungsbeispielen, die in den Fig. 4 und 5 ausschnittsweise dargestellt sind, sind der Emitter 30 des Vergleichstransistors 28 über einen von dem Schaltverstärker 3 angesteuerten Steuerschalter 31 an die Verbindung von Stromzuführungselement 6 und Hilfsschalter 8 und der Kollektor 32 des Vergleichstransistors 28 an den elektronischen Schalter 4 angeschlossen. Bei diesen Ausführungsbeispielen sind die Hilfsspannung für den Anwesenheitsindikator 2 und den Schaltverstärker 3 und die Referenzspannung auf das Minuspotential bezogen, d. h. die Hilfsspannung für den Anwesenheitsindikator 2 und den Schaltverstärker 3 bzw. die Referenzspannung sind die Potentialdifferenz zwischen dem Hilfspotential

bzw. dem Referenzpotential 27 und dem Minuspotential. Selbstverständlich können die zuletzt beschriebenen Ausführungsbeispiele auch invers ausgeführt werden, also so, daß die Hilfsspannung für den Anwesenheitsindikator 2 und den Schaltverstärker 3 bzw. die Referenzspannung auf das Pluspotential bezogen sind. Das bedarf der weiteren Erläuterung nicht.

Die Ausführungsbeispiele, die in den Fig. 4 und 5 dargestellt sind, unterscheiden sich nur insoweit, als bei dem in Fig. 4 dargestellten Ausführungsbeispiel der Steuerschalter 31 Teil des integrierten Schaltkreises 15 ist, während bei dem in Fig. 5 dargestellten Ausführungsbeispiel als Steuerschalter 31 ein außerhalb des integrierten Schaltkreises 15 vorgesehener Transistors dient.

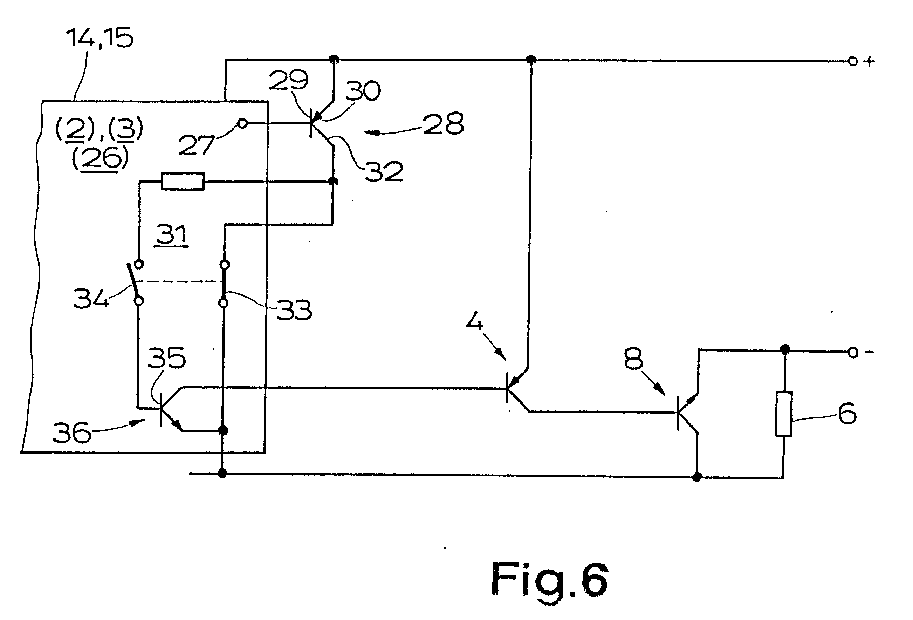

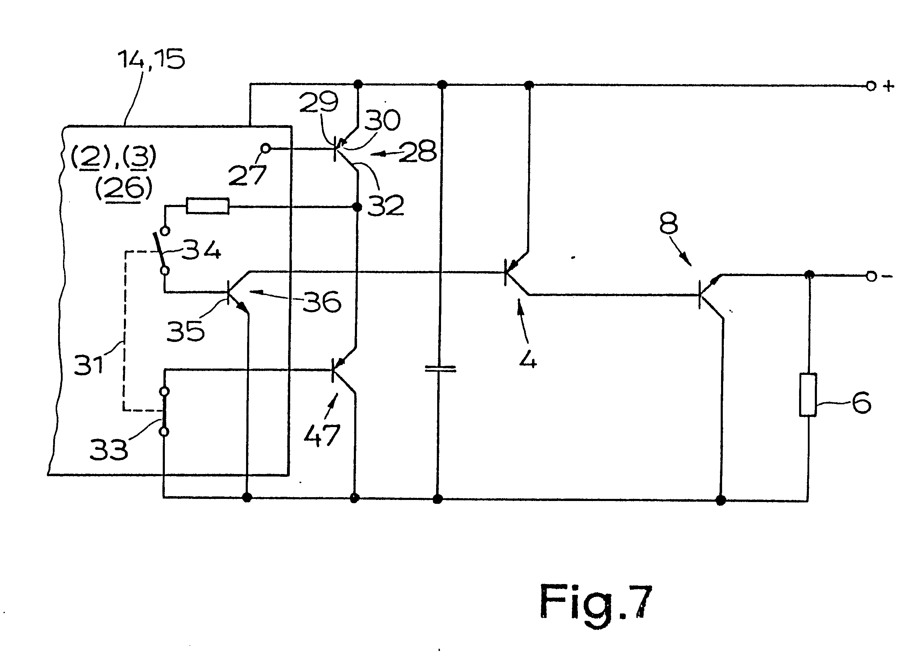

Bei den Ausführungsbeispielen, die in den Fig. 6 und 7 dargestellt sind, sind der Emitter 30 des Vergleichstransistors 28 an das Pluspotential und der Kollektor 32 des Vergleichstransistors 28 entweder über einen Öffner 33 eines von dem Schaltverstärker 3 angesteuerten Steuerschalters 31 an das Minuspotential oder über einen Schließer 34 des Steuerschalters 31 an die Basis 35 eines den elektronischen Schalter 4 ansteuernden Hilfstransistors 36 angeschlossen. Bei diesen Ausführungsbeispielen sind die Hilfsspannung für den Anwesenheitsindikator 2 und den Schaltverstärker 3 und die Referenzspannung auf das Pluspotential bezogen, d. h. die Hilfsspannung für den Anwesenheitsindikator 2 und den Schaltverstärker 3 bzw. die Referenzspannung sind die Potentialdifferenz zwischen dem Hilfspotential bzw. dem Referenzpotential 27 und dem Pluspotential. Selbstverständlich können auch die zuletzt beschriebenen Ausführungsbeispiele wiederum invers ausgeführt werden, also so, daß die Hilfsspannung für den Anwesenheitsindikator 2 und den Schaltverstärker 3 und die Referenzspannung auf das Minuspotential bezogen sind. Das bedarf wiederum der weiteren Erläuterung nicht.

Die in den Fig. 6 und 7 dargestellten Ausführungsbeispiele unterscheiden sich nur insoweit voneinander, als im Ausführungsbeispiel nach Fig. 6 der Kollektor 32 des Vergleichstransistors 28 direkt über den Öffner 33 des Steuerschalters 31 an das Minuspotential angeschlossen ist, während im Ausführungsbeispiel nach Fig. 7 der Öffner 33 des Steuerschalters 31 einen Hilfstransistor 47 ansteuert, über den der Kollektor 32 des Vergleichstransistors 28 an das Minuspotential angeschlossen ist.

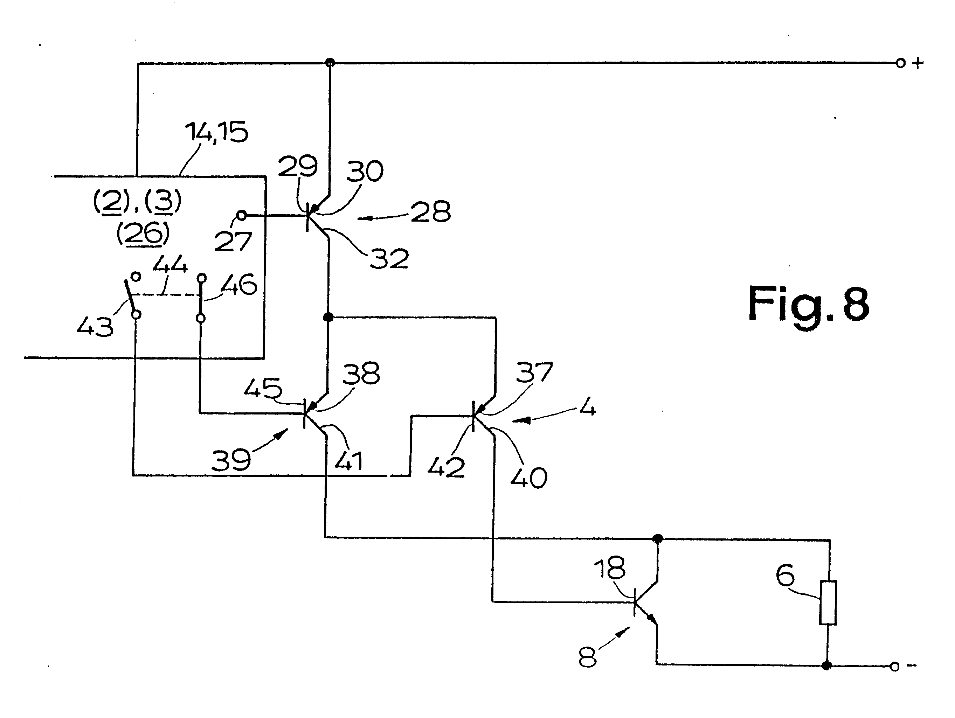

Im Ausführungsbeispiel nach Fig. 8 ist zunächst, wie in den Ausführungsbeispielen nach den Fig. 6 und 7, der Emitter 30 des Vergleichstransistors 28 an das Pluspotential angeschlossen. Der Kollektor 32 des Vergleichstransistors 28 ist an den Emitter 37 des als Transistor ausgeführten elektronischen Schalters 4 und an den Emitter 38 eines Hilfstransistors 39 angeschlossen. Im übrigen sind der Kollektor 40 des als Transistor ausgeführten elektronischen Schalters 4 an die Basis 18 des als Transistor ausgeführten Hilfsschalters 8 und der Kollektor 41 des Hilfstransistors 39 an das Hilfspotential angeschlossen. Schließlich sind entweder die Basis 42 des als Transistor ausgeführten elektronischen Schalters 4 über einen Schließer 43 eines von dem Schaltverstärker 3 angesteuerten Steuerschalters 44 oder die Basis 45 des Hilfstransistors 39 über einen Öffner 46 des Steuerschalters 44 angesteuert. Bei diesem Ausführungsbeispiel sind, wie bei den Ausführungsbeispielen nach den Fig. 6 und 7, die Hilfsspannung für den Anwesenheitsindikator 2 und den Schaltverstärker 3 und die Referenzspannung auf das Pluspotential bezogen. Selbstverständlich kann auch dieses Ausführungsbeispiel invers ausgeführt werden.

Schließlich sei noch angemerkt, daß die Ausführungsbeispiele, die in den Fig. 6 bis 8 dargestellt sind, insoweit vorteilhaft sind, als die Hilfsspannung für den Anwesenheitsindikator 2 und den Schaltverstärker 3 sowohl im gesperrten Zustand als auch im leitenden Zustand durch die gleichen Bauelemente vorgegeben wird, so daß ein Umschalten nicht erforderlich ist. Als Hilfsspannung stellt sich stets ein die durch den Spannungsregler 26 erzeugte Referenzspannung zuzüglich des Spannungsabfalls an der Basis-Emitter-Strecke eines Transistors, also zuzüglich ca. 0,6 V.

**Patentansprüche**

1. Elektronisches, vorzugsweise berührungslos arbeitendes Schaltgerät, das über einen Außenleiter mit einem Pol einer Gleichspannungsquelle und nur über einen weiteren Außenleiter mit einem Anschluß eines Verbrauchers verbindbar ist, wobei der andere Anschluß des Verbrauchers an den anderen Pol der Gleichspannungsquelle anschließbar ist, mit einem von außen beeinflußbaren Anwesenheitsindikator, (2) z. B. einem Oszillator, mit einem von dem Anwesenheitsindikator, ggf. über einen Schaltverstärker (3) steuerbaren elektronischen Schalter, (4) z. B. einem Transistor oder einem Thyristor, und mit einer Hilfsschaltung (5) zur Erzeugung einer Hilfsspannung für den Anwesenheitsindiator und ggf. den Schaltverstärker, wobei die Hilfsschaltung zur Erzeugung einer Hilfsspannung für den Anwesenheitsindikator und ggf. den Schaltverstärker einen Konstantstromgenerator (6) und ein Spannungsbegrenzungselement aufweist, dadurch gekennzeichnet, daß dem Konstantstromgenerator (6) ein Transistor oder ein Thyristor als Hilfsschalter (8) parallelgeschaltet ist, daß der Hilfsschalter (8) von dem Anwesenneitsindikator (2) ggf. über den Schaltverstärker (3) - steuerbar ist und daß im leitenden Zustand der Hauptteil des Laststroms über die Emitter-Basis-Strecke des als Hilfsschalter (8) vorgesehenen Transistors oder über die Anoden-Kathoden-Strecke des als Hilfsschalter (8) vorgesehenen Thyristors fließt und aus einem Hilfsteil des Laststroms die Hilfsspannung für den Anwesenheitsindikator (2) und ggf. den Schaltverstärker (3) gewonnen wird.

2. Elektronisches Schaltgerät nach Anspruch 1, dadurch gekennzeichnet, daß der Konstantstromgenerator (6) aus einem in Emitterschaltung betriebenen des Generatortransistors (9) angeschlossenen Strombegrenzungswiderstand (12), dem an die Basis (l0) des Generatortransistors (9) angeschlossenen Spannungsbegrenzungselement (7), z. B. einer Zenerdiode, und einer an den Emitter (13) des Generatortransistors (9) angeschlossenen Emitterlast (14) besteht.

3. Elektronisches Schaltgerät nach Anspruch 2, dadurch gekennzeichnet, daß die Emitterlast (14) teilweise als monolitisch integrierter Schaltkreis (15) ausgeführt ist und in dem integrierten Schaltkreis (15) teilweise die Bauelemente des Anwesenheitsindikators (2) und ggf. des Schaltverstärkers (3) verwirklicht sind.

4. Elektronisches Schaltgerät nach Anspruch 3, dadurch gekennzeichnet, daß der Hilfsschalter (8) an den integrierten Schaltkreis (15) angeschlossen ist.

5. Elektronisches Schaltgerät nach Anspruch 3 oder 4, dadurch gekennzeichnet, daß der Hilfsschalter (8) über den integrierten Schaltkreis (15) steuerbar ist.

6. Elektronisches Schaltgerät nach einem der Ansprüche 1 bis 5, dadurch gekennzeichnet, daß der Hilfsschalter (8) über einen Ansteuertransistor (16) steuerbar ist.

7. Elektronisches Schaltgerät nach Anspruch 6, wobei als Hilfsschalter ein Transistor vorgesehen ist, dadurch gekennzeichnet, daß zu der Emitter-Kollektor-Strecke des als Hilfsschalter (8) vorgesehenen Transistors die Emitter-Kollektor-Strecke des Ansteuertransistors (16) in Reihe geschaltet ist, ein Ergänzungstransistor (17) vorgesehen ist sowie die Basis (18) des als Hilfsschalter (8) vorgesehenen Transistors an den Kollektor (19) des Ergänzungstransistors (17) und der Kollektor (20) des Ansteuertransistors (16) an die Basis (21) des Ergänzungstransistors (17) angeschlossen sind, - während der Emitter (22) des als Hilfsschalter (8) vorgesehenen Transistors an den Pluspol der Gleichspannungsquelle und der Emitter (23) des Ergänzungstransistors (17) an den Minuspol der Gleichspannungsquelle angeschlossen sind und der Hilfsschalter (8), der Ansteuertransistor (16) und der Ergänzungstransistor (17) zusammen den elektronischen Schalter (4) darstellen.

8. Elektronisches Schaltgerät nach einem der Ansprüche 1 bis 7, dadurch gekennzeichnet, daß zur Gewinnung der Hilfsspannung für den Anwesenheitsindikator (2) und ggf. den Schaltverstärker (3) aus einem Hilfsteil des Laststroms eine Zenerdiode (25) vorgesehen ist.

9. Elektronisches Schaltgerät nach einem der Ansprüche 1 bis 8, dadurch gekennzeichnet, daß die Hilfsschaltung (5) zur Erzeugung der Hilfsspannung für den Anwesenheitsindikator (2) und ggf. den Schaltverstärker (3) einen Spannungsregler (26) zur Erzeugung einer konstanten Referenzspannung aufweist, - so daß ein Referenzpotential (27) zur Verfügung steht.

10. Elektronisches Schaltgerät nach Anspruch 9, dadurch gekennzeichnet, daß ein Vergleichstransistor (28) (oder ein anderer Komparator) vorgesehen ist und die Basis (29) des Vergleichstransistors (28) an das Referenzpotential (27), der Emitter (30) des Vergleichstransistors (28) über einen von dem Anwesenheitsindikator (2) oder dem Schaltverstärker (3) angesteuerten Steuerschalter (31) an die Verbindung von Stromzuführungselement (6) und Hilfsschalter (8) und der Kollektor (32) des Vergleichstransistors (28) an den elektronischen Schalter (4) angeschlossen sind, - wenn die Hilfsspannung für den Anwesenheitsindikator (2) und ggf. den Schaltverstärker (3) bzw. die Referenzspannung die Potentialdifferenz zwischen dem Hilfspotential bzw. dem Referenzpotential (27) und dem Minuspotential sind, bzw. entsprechend invers, wenn die Hilfsspannung für den Anwesenheitsindikator (2) und ggf. den Schaltverstärker (3) bzw. die Referenzspannung die Potentialdifferenz zwischen dem Hilfspotential bzw. dem Referenzpotential (27) und dem Pluspotential sind.

11. Elektronisches Schaltgerät nach Anspruch 9, dadurch gekennzeichnet, daß ein Vergleichstransistor (28) (oder ein anderer Komparator) vorgesehen ist und die Basis (29) des Vergleichstransistors (28) an das Referenzpotential (27), der Emitter (30) des Vergleichstransistors (28) an das Pluspotential und der Kollektor (32) des Vergleichstransistors (28) entweder über einen Öffner (33) eines von dem Anwesenheitsindikator (2) oder von dem Schaltverstärker (3) angesteuerten Steuerschalters (31) an das Minuspotential oder über einen Schließer (34) des Steuerschalters (31) an die Basis (35) eines den elektronischen Schalter (4) ansteuernden Hilfstransistors (36) angeschlossen sind, - wenn die Hilfsspannung für den Anwesenheitsindikator (2) und ggf. den Schaltverstärker (3) bzw. die Referenzspannung die Potentialdifferenz zwischen dem Hilfspotential bzw. dem Referenzpotential (27 und dem Pluspotential sind, bzw. entsprechend invers, wenn die Hilfsspannung für den Anwesenheitsindikator (2) und ggf. den Schaltverstärker (3) bzw. die Referenzspannung die Potentialdifferenzen zwischen dem Hilfspotential bzw. dem Referenzpotential (27) und dem Minuspotential sind.

12. Elektronisches Schaltgerät nach Anspruch 9, dadurch gekennzeichnet, daß ein Vergleichstransistor (28) (oder ein anderer Komparator) vorgesehen ist und die Basis (29) des Vergleichstransistors (28) an das Referenzpotential, der Emitter (30) des Vergleichstransistors (28) an das Pluspotential und der Kollektor (32) des Vergleichstransistors (28. -

den Emitter (37) des als Transistor ausgeführten elektronischen Schalters (4) und an den Emitter (38) eines Hilfstransistors (39) angeschlossen sind, der Kollektor (40) des als Transistor ausgeführten elektronischen Schalters (4) an die Basis (18) des als Transistor ausgeführten Hilfsschalters (8) und der Kollektor (41) des Hilfstransistors (39) an das Hilfspotential angeschlossen sind sowie entweder die Basis (42) des als Transistor ausgeführten elektronischen Schalters (4) über einen Schließer (43) eines von dem Anwesenheitsindikator (2) oder von dem Schaltverstärker (3) angesteuerten Steuerschalters (44) oder die Basis (45) des Hilfstransistors (39) über einen Öffner (46) des Steuerschalters (44) angesteuert sind, - wenn die Hilfsspannung für den Anwesenheitsindikator (2) und ggf. den Schaltverstärker (3) bzw. die Referenzspannung die Potentialdifferenz zwischen dem Hilfspotential bzw. dem Referenzpotential (27) und dem Pluspotential sind, bzw. entsprechend invers, wenn die Hilfsspannung für den Anwesenheitsindikator (2) und ggf. den Schaltverstärker (3) bzw. die Referenzspannung die Potentialdifferenz zwischen dem Hilfspotential bzw. dem Referenzpotential (27) und dem Minuspotential sind.

## Claims

An electronic switching equipment, preferably working without contact, that can be permanently connected by an external lead to one pole of a direct current source and can be permanently connected by only one further external lead to one terminal of a load, the other terminal of the load being connectable to the other pole of the direct current source, with a presence indicator (2) e.g. an oscillator, with an electronic switch (4), e.g. a transistor or a thyristor, controllable from the presence indicator, via a switching amplifier (3) if required, and with an auxiliary circuit (5) for the production of an auxiliary voltage for the presence indicator and if required for the switching amplifier, in which the auxiliary circuit for the production of an auxiliary voltage the presence indicator and if required for the switching amplifier possesses a constant current generator (6) and a voltage-limiting unit (7), characterized in that a transistor or a thyristor is connected in parallel to the constant current generator (6) as auxiliary switch (8), that the auxiliary switch (8) can be controlled from the presence indicator (2) - if required via the switching amplifier (3) - and that in the conducting state the main part of the load current flows through the emitter-base junction of the transistor provided as auxiliary switch (8) or through the anode-cathode junction of the thyristor provided as auxiliary switch (8) and that the auxiliary voltage for the presence indicator (2) and if required for the switching amplifier (3) is obtained from an auxiliary portion of the load current.

2. An electronic switching equipment according to Claim 1, characterized in that the constant current generator (6) consists of a generator transistor (9) driven in the emitter circuit, a current-limiting resistance (12) connected to the base (10) and to the collector (11) of generator transistor (9), the voltage-limiting unit (7), e.g. a zener diode, connected to the base (10) oi generator transistor (9), and an emitter load (14) connected to the emitter (13) of generator transistor (9).

3. An electronic switching equipment according to Claim 2, characterized in that the emitter load (14) is partly constructed as a one-piece integrated circuit (15) and the component parts of the presence indicator (2) and if required the switching amplifier (3) are partly contained in the integrated circuit (15).

4. An electronic switching equipment according to Claim 3, characterized in that the auxiliary switch (8) is connected to the integrated circuit (15).

5. An electronic switching equipment according to Claim 3 or Claim 4, characterized in that the auxiliary switch (8) can be controlled via the integrated circuit (15).

6. An electronic switching equipment according to one of Claims 1 to 5, characterized in that the auxiliary switch (8) can be controlled via a controlling transistor (16).

7. An electronic switching equipment according to Claim 6, in which a transistor is provided as auxiliary switch, characterized in that the emitter-collector junction of the controlling transistor (16) is connected in series with the emitter-collector junction of the transistor provided as auxiliary switch (8), a supplementary transistor (17) is provided and the base (18) of the transistor provided as auxiliary switch (8) is connected to the collector (19) of the supplementary transistor (17) and the collector (20) of the control transistor (16) is connected to the base (21) of the supplementary transistor (17) - whilst the emitter (22) of the transistor provided as auxiliary switch (8) is connected to the positive pole of the direct current source, and the emitter (23 of the supplementary transistor (17) is connected to the negative pole of the direct current source, and the auxiliary switch (8), the controlling transistor (16) and the supplementary transistor (17) together represent the electronic switch (4).

8. An electronic switching equipment according to one of Claims 1 to 7, characterized in that a zener diode (25) is provided to obtain from an auxiliary portion of the load current the auxiliary voltage for the presence indicator (2) and if required the switching amplifier (3).

9. An electronic switching equipment according to one of Claims 1 to 8, characterized in that the auxiliary circuit (5) for the production of an auxiliary voltage for the presence indicator (2) and if required for the switching amplifier (3) possesses a voltage controller (26) for the production of a constant reference voltage - so that a reference potential (27) is available.

10. An electronic switching equipment according to Claim 9, characterized in that a comparison transistor (28) (or another comparator) is provided, and base (29) of the comparison transistor (28) is connected to the reference potential (27) emitter (30) of comparison transistor (28) is connected via a control switch (31) operated by the presence indicator (2) or the switching amplifier (3) to the junction between the current supply unit (6) and the auxiliary switch (8), and the collector (32) of the comparison transistor (28) is connected to the electronic switch (4) - if the auxiliary voltage for the presence indicator (2) and if required the switching amplifier (3), or the reference voltage, is the potential difference between the auxiliary potential or the reference potential (27) and the negative potential, or correspondingly inversely, if the auxiliary voltage for the presence indicator (2) and if required the switching amplifier (3), or the reference voltage, is the potential difference between the auxiliary potential or the reference potential (27) and the positive potential.

11. An electronic switching equipment according to Claim 9, characterized in that a comparison transistor (28) (or another comparator) is provided, and base (29) of the comparison transistor (28) is connected to the reference potential (27), the emitter (30) of the comparison transistor (28) is connected to the positive potential and the collector (32) of the comparison transistor (28) is connected to the negative potential either via the opener (35) of a control switch (31) controlled by the presence indicator (2) or by the switching amplifier (3) or by a closer (34) of the control switch (31) to the base (35) of an auxiliary transistor (36) controlling the electronic switch (4) - if the auxiliary voltage for the presence indicator (2) and if required the switching amplifier (3), or the reference voltage, is the potential difference between the auxiliary potential or the reference potential (27) and the positive potential, or correspondingly inversely, if the auxiliary voltage for the presence indicator (2) and if required the switching amplifier (3), or the reference voltage, is the potential difference between the auxiliary potential or the reference potential (27) and the negative potential.

12. An electronic switching equipment according to Claim 9, characterized in that a comparison transistor (28) (or another comparator) is provided, and the base (29) of the comparison transistor (28) is connected to the reference potential, emitter (30) of the reference transistor (28) is connected to the positive potential and the collector (32) of the comparison transistor (28) is connected to the emitter (37) of electronic switch (4) which is formed as a transistor and to the emitter (38) of an auxiliary transistor (39), the collector (40) of the electronic switch (4) which is formed as a transistor is connected to the base (18) of the auxiliary switch (8) which is formed as a transistor, and the collector (41) of the auxiliary transistor (39) is connected to the auxiliary potential, and either the base (42) of the electronic switch (4) formed as a transistor is controlled via a closing switch (43) of a control switch (44) controlled from the presence indicator (2) or from the switching amplifier (3), or the base (45) of the auxiliary transistor (39) is controlled via an opening switch (46) of the control switch (44) - if the auxiliary voltage for the presence indicator (2) and if required the switching amplifier (3), or the reference voltage, is the potential difference between the auxiliary potential or the reference potential (27) and the positive potential, or correspondingly inversely, if the auxiliary voltage for the presence indicator (2) and if required the switching amplifier (3), or the reference voltage, is the potential difference between the auxiliary potential or the reference potential (27) and the negative potential.

**Revendications**

1. Interrupteur électronique fonctionnant de préférence sans contact, susceptible d'être connecté, d'une part, à l'un des pôles d'une source de tension continue au noyen d'un conducteur extérieur et, d'autre part, à une borne d'un consommateur au moyen d'un autre conducteur extérieur, dont l'autre borne peut être connectée à l'autre pôle de la source de tension continue, ainsi qu'à un détecteur de présence (2) susceptible d'être influencé de l'extérieur et se présentant par exemple sous forme d'un oscillateur, à un interrupteur électronique (4) susceptible d'être commandé par ce détecteur de présence (2), éventuellement par l'entremise d'un amplificateur de signaux (3), et se présentant par exemple sous forme d'un transistor ou d'un thyristor, et à un circuit auxiliaire (5) servant à la génération d'une tension auxiliaire pour le détecteur de présence (2) ou, le cas échéant, pour l'amplificateur de signaux (3), ce circuit auxiliaire servant à la génération d'une tension auxiliaire pour le détecteur de présence (2) et, le cas échéant, pour l'amplificateur de signaux (3) contenant un générateur de courant constant (6) et un limitateur de tension (7), caractérisé en ce qu'avec le générateur de courant constant (6) est connecté en parallèle un transistor ou un thyristor en guise d'interrupteur auxiliaire (8), en ce que cet interrupteur auxiliaire (8) est susceptible d'être commandé par ledit détecteur de présence (2), le cas echéant, par l'entremise dudit amplificateur de signaux (3), en ce que, à l'état conducteur, la majeure partie du courant de charge passe par le trajet émetteur-base dudit transistor faisant office d'interrupteur auxiliaire (8) ou par le trajet anode-cathode dudit thyristor faisant office d'interrupteur auxiliaire (8), et en ce que la tension auxiliaire pour le détecteur de présence (2) et, le cas échéant, pour l'amplificateur de signaux (3) s'obtient à partir d'une partie du courant de charge.

2. Interrupteur électronique selon la revendication 1, caractérisé en ce que ledit générateur de courant (6) se compose d'un

nsistor générateur (9) présent dans un circuil emetteur, d'une résistance limitatrice de courant (12) connectée à la base (18) et au collecteur (11) dudit transistor générateur (9) du limitateur de tension (7) raccurdé à la base (18) du transistor générateur (9) et se présentant, par exemple, sous forme d'une diode Zener, et d'une charge d'émetteur (14) connectée à l'émetteur (13) de ce transistor générateur (9).

3. Interrupteur électronique selon la revendication 2, caractérisé en ce que ladite charge d'émetteur (14) est partiellement exécutée sous forme de circuit intégré monobloc (15) et en ce que dans ce circuit intégré monobloc (15) sont réalisés partiellement les éléments constitutifs dudit détecteur je présence (2) et, le cas échéant, dudit amplificateur de signaux (3).

4. Interrupteur électronique selon la revendication 3, caractérisé en ce que ledit interrupteur auxiliaire (8) est connecté audit circuit intégré (15).

5. Interrupteur électronique selon la revendication 3 ou 4, caractérisé en ce que ledit interrupteur auxiliaire (8) est susceptihle d'être commandé par l'entremiae dudit circuit intégré (15).

6. Interrupteur électronique selon l'une ou l'autre des revendications précédentes 1-5, caractérisé en ce que ledit interrupteur auxiliaire (8) est susceptible d'être commandé par l'entremise d'un transistor de commande (16).

7. Interrupteur électronqiue selon la revendication 6, muni d'un transistor en guise d'interrupteur auxiliaire, charactérisé en ce qu'avec la trajet émetteur-collecteur dudit transistor faisant office d'interrupteur auxiliaire (8) est connecté en série la trajet émetteur-collecteur dudit transistor de commande (16), en ce qu'est prévu un transistor complémentaire (17) et que la base (18) dudit transistor faisant office d'interrupteur auxiliaire (8) est connectée au collecteur (19) du transistor complémentaire (17) et le collecteur (20) du transistor de conmande (16) est connecté à la base (21) du transistor complémentaire (17), tandis que l'émetteur (22) dudit transistor faisant office d'interrupteur auxiliaire (8) est connecté au pôle positif de la source de tension continue et l'émetteur (23) dudit transistor complémentaire (17) est raccordé au pôle négatif de la source de tension continue, et en ce que lesdits interrupteur auxiliaire (8), transistor de commande (16) et transistor complémentaire (17) forment ensemble l'interrupteur électronique (4).

8. Interrupteur électronique selon l'une ou l'autre des revendications 1-7, caractérisé en ce qu'est prévue une diode Zener (25) pour la formation de la tension auxiliaire pour ledit détecteur de présence (2) et, le cas échéant, pour ledit amplificateur de signaux (3) à partir d'une partie auxiliaire du courant de charge.

9. Interrupteur électronique selon l'une ou l'autre des revendications précédentes 1-8, caractérisé en ce qu'est prévue une diode Zener (25) pour la production de la tension auxiliaire pour le détecteur de présence (2) et, le cas échéant, pour l'amplificateur de signaux (3) à partir d'une partie auxiliaire du courant de charge.

10. Interrupteur électronique selon la revendication 9, caractérisé en ce qu'est prévu un transistor de comparaison (28) ou un autre comparateur approprié, en ce que la base (29) de ce transistor de comparaison (28) est raccordée au potentiel de référence (27), l'émetteur (30) de ce transistor de comparaison (28) est, par l'entremise d'un interrupteur de commande (31) commandé par ledit détecteur de présence (2) au ledit amplificateur de signaux (3), raccordé au point de raccord entre l'élément d'amenée de courant (6) et ledit interrupteur auxiliaire (8), et le collecteur (32) dudit transistor de comparaison (28) est connecté audit interrupteur électronique (4), lorsque la tension auxiliaire pour le détecteur de présence (2) ou, le cas échéant, pour l'amplificateur de signaux (3) ou la tension de référence est la différence de potentiel entre le potentiel auxiliaire ou le potentiel de référence (27) et le potentiel négatif, ou en est l'inverse, lorsque la tension auxiliaire pour le détecteur de présence (2) et, le cas échéant, pour l'amplificateur de signaux (3) ou la tension de référence est la différence de potentiel entre le potentiel auxiliaire ou le potentiel de référence (27) et le potentiel positif.

11. Interrupteur électronique selon la revendication 9, caractérisé en ce qu'est prévu un transistor de comparaison (28) ou un autre comparateur approprié et la base (29) de ce transistor de comparaison (28) est connectée au potentiel de référence (27), l'émetteur (30) de ce transistor de comparaison (28) est connecté au potentiel positif et le collecteur (32) de ce transistor de comparaison (28) est connecté, soit par l'entremise d'un déconnecteur (33) d'un interrupteur (31) commandé par ledit détecteur de présence (2) ou ledit amplificateur de signaux (3), au potentiel négatif, soit par l'entremise d'un contacteur (34) de l'interrupteur de commande (31) à la base d'un transistor auxiliaire (36) commandant ledit interrupteur électfonique (4), lorsque la tension auxiliaire pour le détecteur de présence (2) ou, le cas échéant, pour l'amplificateur de signaux (3) ou la tension de référence est la différence de potentiel entre le potentiel auxiliaire ou le potentiel de référence (27) et le potentiel positif, ou en est l'inverse, lorsque la tension auxiliaire pour le détecteur de présence (2) et, le cas échéant, pour l'amplification de signaux (3) ou la tension de référence est la différence de potentiel entre le potentiel auxiliaire ou le potentiel de référence (27) et le potentiel négatif.

12. Interrupteur électronique selon la revendication 9, caractérisé en ce qu'est prévu un transistor de comparaison (28) ou un autre comparateur approprié, et en ce que la base (29) de ce transistor de comparaison (28) est connectée au potentiel de référence, l'émetteur de ce transistor de comparaison (28) est connecté au potentiel positif et le collecteur (32) de ce transistor de comparison (28) est connecté à l'emetteur (37) dudit transistor faisant office d'interrupteur électronique (4) et à l'emetteur (38) d'un transistor auxiliaire (39), en ce que le collecteur (40) de ce transistor faisant office d'interrupteur électronique (4) est connecté à la base (18) du transistor faisant office d'interrupteur auxiliaire (8) et le collecteur (41) du transistor auxiliaire (39) est connecté au potentiel auxiliaire, et la base (42) du transistor faisant office d'interrupteur électronique (4) est commandée par l'entremise d'un contacteur (43) d'un interrupteur de commande (44) commandé par le détecteur de présence (2) ou par l'amplificateur de signaux (3) ou la base (45) du transistor auxiliaire (39) est commandé par l'entremise d'un déconnecteur (46) dudit transistor de commande, lorsque la tension auxiliaire pour ce détecteur de présence (2) ou, le cas échéant, pour cet amplificateur de signaux (3) ou la tension de référence est la différence de potentiel entre le potentiel auxiliaire ou le potentiel de référence (27) et le potentiel positif, ou en est l'inverse, lorsque la tension auxiliaire pour le détecteur de présence (2) et, le cas échéant, pour l'amplificateur de signaux (3) ou la tension de référence est la différence de potentiel entre le potentiel auxiliaire ou le potentiel de référence (27) et le potentiel positif.

Fig.1

Fig.2

Fig.3

0 092 710

**Fig.4**

0 092 710

Fig.5

0 092 710

Fig.6

14,15

(2),(3)
(26)

29    30
27        28
        32
31
34    33
35
36    4
8
6
+
−

0 092 710

11

Fig.7

0 092 710

13

Fig. 8